# EUROPÄISCHE PATENTSCHRIFT

(11) **EP 1 775 757 B1**
(45) Veröffentlichungstag und Bekanntmachung des Hinweises auf die Patenterteilung: **03.10.2012**
(21) Anmeldenummer: 05022314.8
(22) Anmeldetag: 13.10.2005
(51) Int. Cl.: H01L 21/20, H01L 21/18

(54) **Verfahren zum Bonden von Wafern**
A method for bonding wafers
Un procédé pour joindre des wafers

(43) Veröffentlichungstag der Anmeldung: 18.04.2007
(60) Teilanmeldung: 10005551.6
(73) Patentinhaber: Thallner, Erich, 4782 St. Florian (AT)
(72) Erfinder: Thallner, Erich, 4782 St. Florian (AT)
(74) Vertreter: Schweiger, Johannes

(56) Entgegenhaltungen:
- GB-A- 2 263 015
- US-A- 4 339 295
- US-A- 5 421 953
- US-A- 5 904 860
- US-A1- 2004 009 649
- US-B1- 6 548 176
- US-B1- 6 905 945
- PATENT ABSTRACTS OF JAPAN Bd. 017, Nr. 193 (E-1351), 15. April 1993 (1993-04-15) -& JP 04 342110 A (FUJITSU LTD), 27. November 1992 (1992-11-27)
- PLOSZL A ET AL: "Wafer direct bonding: tailoring adhesion between brittle materials", MATERIALS SCIENCE AND ENGINEERING R: REPORTS, ELSEVIER SEQUOIA S.A., LAUSANNE, CH LNKD- DOI:10.1016/S0927-796X(98)00017-5, vol. 25, no. 1-2, 10 March 1999 (1999-03-10), pages 1-88, XP004167445, ISSN: 0927-796X
- PATENT ABSTRACTS OF JAPAN vol. 017, no. 193 (E-1351), 15 April 1993 (1993-04-15) -& JP 04, 342110, A, (FUJITSU LTD), 27 November 1992 (1992-11-27)

## Beschreibung

Die Erfindung betrifft ein Verfahren zum Bonden von Wafern.

In der Halbleiterindustrie ist es notwendig, Wafer aus verschiedenen oder auch gleichen Materialien miteinander zu verbinden (bonden). Dazu werden die Wafer üblicherweise zunächst einem Reinigungsschritt mit deionisiertem Wasser unterworfen. Nach einem auf den Reinigungsschritt folgenden Trocknungsschritt werden die Wafer in Kontakt zueinander gebracht. Die nach dem Trocknungsschritt verbleibenden Restwassermoleküle sorgen dafür, dass die Wafer bereits nach dem in Kontakt bringen aufgrund von Van-der-Waals-Kräften aneinander haften. Nach dem in Kontakt bringen werden die Wafer in einen Ofen eingebracht und bei Temperaturen von bis zu 1000° C oder darüber erhitzt. Aufgrund der Wärmeeinwirkung verbinden sich die Wafer entlang der Berührungsflächen zu einem atomaren Verband, der eine wesentlich höhere Verbindungsstärke (Bondstärke) aufweist, als die bereits bei Raumtemperatur auftretenden Van-der-Waals-Kräfte.

Nachteilig bei dem bekannten Verfahren ist, dass die auftretenden hohen Temperaturen zu einer Beschädigung der Wafer führen können, insbesondere wenn die Wafer bereits verschiedene Prozessschritte durchlaufen haben. Die hohen Temperaturen können beispielsweise zu einer Zerstörung von auf dem Wafer befindlichen Bauteilen führen.

Um die zum Bonden notwendige Temperatur herabzusetzen, wird bereits versucht, die Waferoberflächen beispielsweise durch Plasmaaktivierung vorzubehandeln, um bereits bei Temperaturen von bis zu etwa 400° C eine ebenso hohe Bondstärke wie bei dem herkömmlichen, temperaturintensiven Verfahren zu realisieren.

Die US 6,548,176 B1 beschreibt die Verwendung von Mikrowellen nach einem Ausheilvorgang bei der Herstellung von Lasersystemen. Weitere Bonding Methoden sind in der US 5,421,953 und der JP 04342110 A beschrieben. W.B. Choi et al "Wafer to Wafer Direct Bonding Using Surfaces Activated by Hydrogen Plasma Treatment", 1999 IEEE/CPMT Int'1 Electronics Manufacturing Technology Symposium beschreibt eine Plasmaaktivierung vor dem Bonden zum Zwecke der Reinigung der Oberflächen. A Plößl et al., Vofer direct bonding: tailoring adhesion between brittle materiels Science and Engineering beschreibt verschiedene verfahren zum Bonden von Wafern.

Der Erfindung liegt die Aufgabe zugrunde, ein schonenderes Verfahren zum Bonden von Wafern vorzuschlagen, mit denen eine ausreichend hohe Bondstärke realisierbar ist.

Diese Aufgabe wird verfahrensgemäß mit den Merkmalen des Anspruchs 1 gelöst. Vorteilhafte Ausgestaltungen der Erfindung sind in den Unteransprüchen angegeben.

Erfindungsgemäß ist vorgesehen, dass die glatt polierten Wafer mit ihren Waferoberflächen in Kontakt gebracht werden. Eine vorherige Benetzung zumindest einer in Kontakt zu bringenden Waferoberfläche mit einer molekularen Dipolverbindung sorgt für das Aneinanderhaften der Wafer aufgrund von Van-der-Waals-Kräften. Nachdem die Wafer miteinander in Kontakt gebracht wurden, werden die Wafer, bzw. die zu verbindenden Abschnitte der Wafer, mittels Mikrowellen bestrahlt. Hierdurch wird die molekulare Dipolverbindung zu Schwingungen angeregt. Die aufgenommene Energie wird von der Dipolverbindung als Wärme abgegebenen, was zu einer Erhitzung der Wafer unmittelbar im Kontaktierungsbereich führt. Hierdurch verbinden sich die Wafer dauerhaft miteinander. Die Dauer und die Höhe der eingebrachten Mikrowellenenergie kann je nach Wafermaterial und benötigter Bondstärke variiert werden. Es ist jedoch vorteilhaft, die Parameter derart zu wählen, dass nur eine geringe Erwärmung der Wafer insgesamt resultiert. Dies kann insbesondere durch eine kurze absolute Bestrahlungsdauer und/oder durch eine gepulste Bestrahlung erreicht werden. Durch die Verwendung von Mikrowellen zur Herstellung einer atomaren Verbindung zwischen den zu verbindenden Wafern kann auf das Einbringen der Wafer in einen Ofen und die damit verbundene Erhitzung der gesamten Wafer verzichtet werden. Die Temperaturbelastung der Wafer ist mit dem erfindungsgemäßen Verfahren gering.

Da mittels der Erfindung hohe Temperaturbelastungen der Wafer vermieden werden können, eignet sich das erfindungsgemäße Verfahren sowie die erfindungsgemäße Vorrichtung insbesondere zum Verbinden von Wafern, bestehend aus unterschiedlichen Materialien, die einen stark voneinander abweichenden Ausdehnungskoeffizienten aufweisen. Da die Temperatur der Wafer aufgrund der Mikrowellenbestrahlung im Vergleich zu der Behandlung im Ofen nur gering ansteigt, erfolgt auch nur eine geringe Ausdehnung der zu verbindenden Materialien. Hierdurch kann eine exakt ausgerichtete Verbindung sichergestellt werden.

Erfindungsgemäß ist vorgesehen, dass die zur Bestrahlung eingesetzten Mikrowellen elektromagnetische Wellen aus einem Frequenzbereich zwischen 0,3 GHz und 300 GHz sind. Vorzugsweise beträgt die Frequenz der zur Anwendung kommenden elektromagnetischen Wellen etwa 18 GHz. Es kann jedoch von Vorteil sein, elektromagnetische Wellen in einem Bereich von 2 bis 3 GHz einzusetzen. Bevorzugt wird eine Frequenz von etwa 2,45 GHz angestrebt. Mittels der Mikrowellen wird die zwischen den Wafern befindliche Molekulare Dipolverbindung zu Schwingungen angeregt. Die absorbierte Energie wird in Form von Wärme abgegeben. Die Verwendung von Mikrowellen mit einer Frequenz von etwa 2,45 GHz ist von Vorteil, da Mikrowellen dieser Frequenz auch in handelsüblichen Mikrowellenöfen verwendet werden, wodurch die zur Erzeugung der Mikrowellen in diesem Frequenzbereich verwendeten Magnetrons besonders kostengünstig erworben werden können, was sich wiederum positiv auf die Herstellungskosten der Halbleiter auswirkt.

In Weiterbildung der Erfindung ist mit Vorteil vorgesehen, dass als molekulare Dipolverbindung zwischen den zu verbindenden Wafern deionisiertes Wasser verwendet wird. Es ist von entscheidendem Vorteil, wenn es sich bei diesem deionisierten Wasser um Restwassermoleküle eines vorhergehenden Reinigungs- und Trocknungsschrittes der Wafer handelt. Die Wafer werden vor dem Einbringen in die Bondvorrichtung mittels deionisiertem Wasser gereinigt. Das nach einem darauf folgenden Trocknungsprozess an der Waferoberfläche anhaftende molekulare Restwasser reicht aus, um die Wafer mittels der Van-der-Waals-Kräfte aneinander zu binden und bei einer anschließenden Bestrahlung ausreichend Wärme zur Verbindung der Wafer zu erzeugen. Auf einen zusätzlichen Benetzungsschritt kann mit Vorteil verzichtet werden, da die Wafer durch den Reinigungsprozess ausreichend hydrophilisiert sind.

Bevorzugt erfolgt das in Kontakt bringen der Wafer bei einer Umgebungstemperatur zwischen 10° C und 30° C, vorzugsweise bei etwa 20° C.

In Ausgestaltung der Erfindung ist mit Vorteil vorgesehen, dass die Wafer vor dem in Kontakt bringen zueinander definiert ausgerichtet werden. Hierfür ist eine Justiereinrichtung vorgesehen, die ein Verfahren mindestens eines Wafers in der Ebene, also in x- und y-Richtung erlaubt. Zusätzlich ist es von Vorteil, wenn die Justiereinrichtung das Drehen zumindest eines Wafers relativ zu dem anderen Wafer um eine senkrecht zur x- y- Ebene verlaufende Drehachse gestattet.

Eine Vorrichtung zum Bonden von Wafern umfasst Mittel zum in Kontakt bringen der Wafer. Anders ausgedrückt bedeutet dies, dass die Wafer mittels einer Einrichtung aufeinander zu bewegbar sind. Je nach Anwendungsfall kann das in Kontakt bringen nahezu drucklos oder mit einer vorgegebenen Anpresskraft erfolgen. Ferner umfasst die Vorrichtung eine Mikrowellenbestrahlungseinrichtung. Zur Erzeugung der Mikrowellen werden mit Vorteil Laufzeitröhren, insbesondere Klystrons oder Magnetrons, eingesetzt.

Meist unmittelbar nach einem Reinigungs- und Trocknungsschritt oder einer Plasmabehandlung werden die Wafer, beispielsweise über Greifer, an Halteeinrichtungen innerhalb der Vorrichtung übergeben und dort, insbesondere durch Anlegen eines Vakuums, fixiert.

In Ausgestaltung der Erfindung ist vorgesehen, dass die Vorrichtung mindestens eine Justiereinrichtung zum definierten Ausrichten der Wafer zueinander umfasst. Insbesondere erlaubt die Justiereinrichtung das Verfahren zumindest eines Wafers in der Ebene, also in x- und y-Richtung. Ferner ist es von Vorteil, wenn die Justiereinrichtung ein Verdrehen des Wafers in der x-y-Ebene um einen Drehpunkt erlaubt. Mit Vorteil umfasst die Justiereinrichtung mindestens zwei Mikroskope mit je mindestens einer CCD-Kamera. Die Mikroskop-Kameraeinheiten sind auf Verstelleinheiten justiert, die eine Verstellung in x-, y- und z-Richtung erlauben. Durch die Ausrichtung der Mikroskope an Justierpunkten eines ersten Wafers wird die exakte Position des Wafers bestimmt. Über die Justiereinrichtung wird nun ein zweiter Wafer zu der vorher durch die Mikroskope angefahrenen und gespeicherten Position des ersten Wafers justiert. Daraufhin erfolgt das Zusammenführen der beiden Wafer, so dass eine physische Berührung sichergestellt wird. Nach dem Justieren und in Kontakt bringen, ggf. mit Anpressdruck, erfolgt die Bestrahlung mittels Mikrowellen.

Weitere Vorteile und zweckmäßige Ausführungen sind aus den weiteren Ansprüchen, der Figurenbeschreibung und den Zeichnungen zu entnehmen.

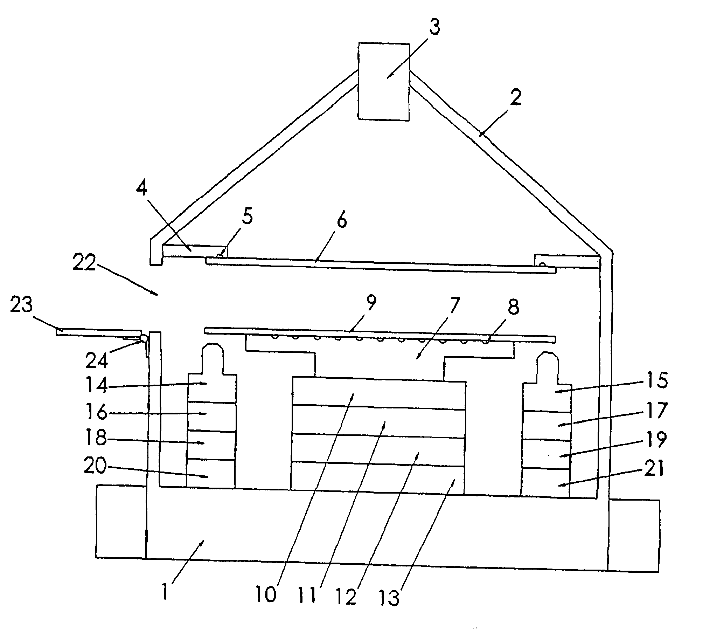

Die einzige Fig. 1 zeigt eine Vorrichtung zum Bonden zweier Wafer.

Die Vorrichtung 1 besteht aus einem Gehäuse 2, welches in seinem oberen Bereich als spitz zulaufende Haube ausgebildet ist. Zentrisch im oberen Bereich des Gehäuses 2 befindet sich eine als Magnetron ausgebildete Mikrowellenbestrahlungseinrichtung 3. Innerhalb des mikrowellendichten Gehäuses 2 ist im unteren Bereich der Haube eine erste Halteeinrichtung 4 bestehend aus einem umlaufenden Ring mit Vakuumnut 5 vorgesehen. Mittels der ersten Halteeinrichtung 4 kann ein erster Wafer 6 durch Anlegen eines Vakuums an die Vakuumnut 5 fixiert werden.

Unterhalb des ersten Wafers 6 ist eine zweite Halteeinrichtung 7 (Chuck) angeordnet, die mehrere Vakuumrillen 8 aufweist. Durch Anlegen eines Vakuums an die Vakuumrillen 8 ist ein zweiter Wafer 9 parallel zu dem ersten Wafer 6 fixierbar.

Die zweite Halteeinrichtung 7 ist auf vier Verstelleinrichtungen 10, 11, 12, 13 fixiert. Die oberste Verstelleinrichtung 10 dient zum Verstellen der zweiten Halteeinrichtung 7 mit zweitem Wafer 9 entlang einer x-Achse (siehe eingezeichnetes Koordinatensystem). Die zweite Verstelleinrichtung 11 von oben dient zum Verstellen der zweiten Halteeinrichtung 7 entlang einer y-Achse. Die y-Achse befindet sich in der selben Ebene wie die x-Achse und verläuft im 90°-Winkel hierzu. Die dritte Verstelleinrichtung 12 dient zum Verstellen der zweiten Halteeinrichtung 7 mit zweitem Wafer 9 in Richtung des ersten Wafers, also in z-Richtung. Mittels der dritten Verstelleinrichtung 12 können die beiden Wafer 6, 9 in Kontakt zueinander gebracht werden. Die unterste Verstelleinrichtung 13 dient zum Verdrehen der zweiten Halteeinrichtung 7 mit zweitem Wafer 9 in der x-, y-Ebene. Die erste, zweite und vierte Verstelleinrichtung 10, 11, 13 sind Teil einer Justiereinrichtung.

Zu der Justiereinrichtung gehören zwei beabstandet angeordnete verstellbare Mikroskope 14, 15 mit integrierter CCD-Kamera. Beide Mikroskop-Kameraeinheiten 14, 15 sind auf jeweils drei Verstelleinrichtungen 16, 18, 20 und 17, 19, 21 montiert. Mittels der obersten Verstelleinrichtungen 16, 17 können die Mikroskope 14, 15 in x-Richtung verstellt werden. Die darunter befindlichen Verstelleinrichtungen 18, 19 dienen zum Verstellen der Mikroskope 14,15 in y-Richtung. Mittels der zuunterst angeordneten Verstelleinrichtungen 20, 21 wird eine Verstellung der Mikroskope 14, 15 in z-Richtung, also in Richtung des ersten Wafers 6 realisiert.

Die Kammer weist eine seitliche Öffnung 22 auf, um ein Beladen der ersten und der zweiten Halteeinrichtung 4, 5 mit den ersten und zweiten Wafern 6, 9 zu ermöglichen. Die Öffnung 22 ist mittels eines Deckels 23 verschließbar. Der Deckel 23 ist mittels eines Scharniers 24 am Gehäuse 2 gehalten.

### Der Bondprozess läuft wie folgt ab:

Ein meist unmittelbar von einem Reinigungs- und Trocknungsprozess oder aus einer Plasmakammer kommender erster Wafer 6 wird über einen nicht dargestellten Greifer an die erste ringförmige Halteeinrichtung 4 übergeben und dort mittels Vakuum fixiert. Nach dem Fixieren des ersten Wafers 6 werden die beiden Mikroskope mit integrierter CCD-Kamera zu nicht dargestellten Justierpunkten des ersten Wafers 6 ausgerichtet. Hierzu dienen die Verstelleinrichtungen 16, 17, 18, 19, 20, 21. Die Positionen der Justierpunkte werden in einer Steuereinheit gespeichert. Daraufhin wird der zweite Wafer 9, ebenfalls nach entsprechendem Reinigung- und Trocknungsprozess oder nach Vorbehandlung in einer Plasmakammer auf der zweiten Halteeinrichtung 7 mittels Vakuum fixiert. Über die Verstelleinheiten 10, 11, 13 wird daraufhin der zweite Wafer 9 zu den vorher durch die Mikroskope 14, 15 angefahrenen und gespeicherten Justierpunkten des ersten Wafers 6 justiert. Am Ende dieses Justierungsprozesses wird der zweite Wafer 9 mittels der dritten Verstelleinrichtung 12 an den ersten Wafer 6 herangefahren, so dass eine physische Berührung der beiden Wafer 6, 9 erfolgt. Zwischen den beiden Wafern befindet sich molekulares deionisiertes Restwasser von dem nicht näher erläuterten Reinigungsprozess. Die beiden Wafer 6, 9 werden zu diesem Zeitpunkt von Van-der-Waals-Kräften aneinander gehalten. Nach dem Schließen der Klappe 23 werden die Wafer 6, 9 mittels der Mikrowellenbestrahlungseinrichtung 3 für eine vorgegebene Zeit bestrahlt. Durch die Einbringung dieser Strahlungsenergie wird die hydrophilisierte Oberfläche der Wafer angeregt und ein permanenter Bond erzeugt.

### Bezugszeichenliste

- 1: Vorrichtung
- 2: Gehäuse
- 3: Mikrowellenbestrahlungseinrichtung
- 4: erstes Halteelement
- 5: Vakuumnut
- 6: erster Wafer
- 7: zweites Halteelement
- 8: Vakuumrillen
- 9: zweiter Wafer
- 10: Verstelleinrichtung x-Achse
- 11: Verstelleinrichtung y-Achse
- 12: Verstelleinrichtung z-Achse
- 13: Verstelleinrichtung (Rotationseinrichtung)
- 14: Mikroskop mit integrierter CCD-Kamera
- 15: Mikroskop mit integrierter CCD-Kamera
- 16: Verstelleinrichtung x-Achse
- 17: Verstelleinrichtung x-Achse
- 18: Verstelleinrichtung y-Achse
- 19: Verstelleinrichtung y-Achse
- 20: Verstelleinrichtung z-Achse
- 21: Verstelleinrichtung z-Achse

## Patentansprüche

1. Verfahren zum Bonden von Wafern (6, 9) mit folgenden Verfahrensschritten:
• Benetzen zumindest einer Waferoberfläche mit einer molekularen Dipolverbindung
• in Kontakt bringen der zu verbindenden Wafer (6, 9), wobei die Wafer (6, 9) anschließend mittels Mikrowellen bestrahlt und hierbei durch Erwärmung der Dipolverbindung gebondet werden, **dadurch gekennzeichnet,**
**dass** als molekulare Dipolverbindung deionisiertes Wasser verwendet wird und dass es sich bei dem deionisierten Wasser um Restwassermoleküle
eines vorhergehenden Reinigungs- und Trocknungsschrittes handelt.

2. Verfahren nach Anspruch 1,
**dadurch gekennzeichnet,**
**dass** die zur Bestrahlung eingesetzten Mikrowellen elektromagnetische Wellen mit einer Frequenz zwischen 0,3 GHz und 300 GHz, vorzugsweise von etwa 18 GHz, insbesondere von etwa 2 bis 3 GHz, bevorzugt von etwa 2,45 GHz, sind.

3. Verfahren nach einem der vorhergehenden Ansprüche,
**dadurch gekennzeichnet,**
**dass** das in Kontakt bringen der Wafer (6, 9) bei einer Umgebungstemperatur zwischen 10°C und 30°C, vorzugsweise bei etwa 20°C, erfolgt.

4. Verfahren nach einem der vorhergehenden Ansprüche,
**dadurch gekennzeichnet,**
**dass** das in Kontakt bringen nach einer vorherigen Plasmaaktivierung zumindest einer Waferoberfläche erfolgt.

5. Verfahren nach einem der vorhergehenden Ansprüche,
**dadurch gekennzeichnet,**
**dass** Wafer (6, 9) aus gleichen oder unterschiedlichen Materialien verbunden werden.

6. Verfahren nach einem der vorhergehenden Ansprüche,
**dadurch gekennzeichnet,**
**dass** die Wafer (6, 9) vor dem in Kontakt bringen zueinander ausgerichtet werden.

## Claims

1. A method for bonding wafers (6, 9), with the following process stages:
• wetting of at least one wafer surface with a molecular dipolar compound,
• bringing the wafers to be bonded (6, 9) into contact with each other, wherein the wafers (6, 9) are subsequently irradiated by means of microwaves and are hereby bonded by heating the dipolar compound,
**characterised in that** deionised water is used as the molecular dipolar compound and that the deionised water consists of residual water molecules from a preceding cleaning and drying stage.

2. The method according to Claim 1, **characterised in that** the microwaves used for the irradiation are electromagnetic waves with a frequency of between 0.3 GHz and 300 GHz, preferably approx. 18 GHz, in particular from approximately 2 to 3 GHz, and most preferably of approximately 2.45 GHz.

3. The method according to one of the preceding claims, **characterised in that** the wafers (6, 9) are brought into contact with each other at an ambient temperature of between 10°C and 30°C, preferably at approximately 20°C.

4. The method according to one of the preceding claims **characterised in that** the contacting with each other takes place after prior plasma activation of at least one wafer surface.

5. The method according to one of the preceding claims **characterised in that** wafers (6, 9) are bonded from the same or different materials.

6. The method according to one of the preceding claims, **characterised in that** the wafers (6, 9) are aligned with each other before being brought into contact.

## Revendications

1. Procédé de métallisation de plaquettes (6, 9), comprenant les étapes de procédé suivantes consistant à :
• humidifier au moins une surface de plaquette avec un composé dipolaire moléculaire,
• mettre en contact les plaquettes (6, 9) à relier, les plaquettes (6, 9) étant ensuite irradiées au moyen de microondes tout en étant métallisées par échauffement du composé dipolaire, **caractérisé**
**en ce que** de l'eau déminéralisée est utilisée en tant que composé dipolaire moléculaire, et
**en ce que** l'eau déminéralisée correspond à des molécules d'eau résiduelle d'une étape précédente de nettoyage et de séchage.

2. Procédé selon la revendication 1,
**caractérisé**
**en ce que** les microondes mises en oeuvre pour l'irradiation sont des ondes électromagnétiques d'une fréquence entre 0,3 GHz et 300 GHz, de préférence d'environ 18 GHz, en particulier d'environ 2 à 3 GHz, de préférence d'environ 2,45 GHz.

3. Procédé selon l'une quelconque des revendications précédentes,
**caractérisé**
**en ce que** la mise en contact des plaquettes (6, 9) s'effectue à une température ambiante entre 10°C et 30 °C, de préférence à environ 20°C.

4. Procédé selon l'une quelconque des revendications précédentes,
**caractérisé**
**en ce que** la mise en contact est effectuée après une activation par plasma précédente d'au moins une surface de plaquette.

5. Procédé selon l'une quelconque des revendications précédentes,
**caractérisé**
**en ce que** des plaquettes (6, 9) composées de matériaux identiques ou différentes sont reliées.

6. Procédé selon l'une quelconque des revendications précédentes,
**caractérisé**
**en ce que** les plaquettes (6, 9) sont alignées les unes par rapport aux autres avant la mise en contact.
